# EUROPEAN PATENT APPLICATION

(11) **EP 2 434 551 A2**
(43) Date of publication of application: **28.03.2012**
(21) Application number: 10827171.9
(22) Date of filing: 02.11.2010
(51) Int. Cl.: H01L 31/042

(54) **SOLAR CELL AND MANUFACTURING METHOD THEREOF**

(30) Priority: 02.11.2009 KR 20090105185
(71) Applicant: LG Innotek Co., Ltd., Seoul 100-714 (KR)
(72) Inventor: LEE, Dong Keun, Seoul 100-714 (KR); KWON, Se Han, Seoul 100-714 (KR)
(74) Representative: Bethenod, Marc
(86) International application number: PCT/KR2010/007647
(87) International publication number: WO 2011/053087

(57) **Abstract**

There is provided a solar cell according to an exemplary embodiment includes: an upper substrate placed on cells of the solar cell; and a hologram pattern placed on the upper substrate.

There is provided a manufacturing method of a solar cell according to another exemplary embodiment includes: forming an upper substrate on cells of the solar cell; and forming a hologram pattern on the upper substrate.

## Description

### TECHNICAL FIELD

Exemplary embodiments relate to a solar cell and a manufacturing method thereof.

### BACKGROUND

In recent years, with the increase in demands for energy, solar cells converting solar energy into electric energy have been developed.

In particular, a CIGS-based solar cell which is a pn hetero junction device having a substrate structure including a glass substrate, an electrode layer on a rear surface of metal, a p-type CIGS-based light absorbing layer, a high resistance buffer layer, and an n-type window layer has been widely used.

Further, as photoelectric conversion efficiency of the solar cell is improved, a lot of solar power generating systems including solar power generating modules are used for residential use and installed outside a commercial building.

An exterior and a display function of the solar cell have been on the rise in order to improve an aesthetic function of the solar cell.

### SUMMARY

Exemplary embodiments provide a solar cell and a manufacturing method thereof that can provide an aesthetic sense and decorativeness.

An exemplary embodiment of the present invention provides a solar cell, including: an upper substrate placed on cells of the solar cell; and a hologram pattern placed on the upper substrate.

Another exemplary embodiment of the present invention provides a manufacturing method of a solar cell, including: forming an upper substrate on cells of the solar cell; and forming a hologram pattern on the upper substrate.

In a solar cell and a manufacturing method thereof according exemplary embodiments, a hologram pattern layer is formed on an upper substrate and an interference pattern is generated due to an interference phenomenon generated on the hologram pattern layer to provide an aesthetic sense and decorativeness.

### BRIEF DESCRIPTION OF THE DRAWINGS

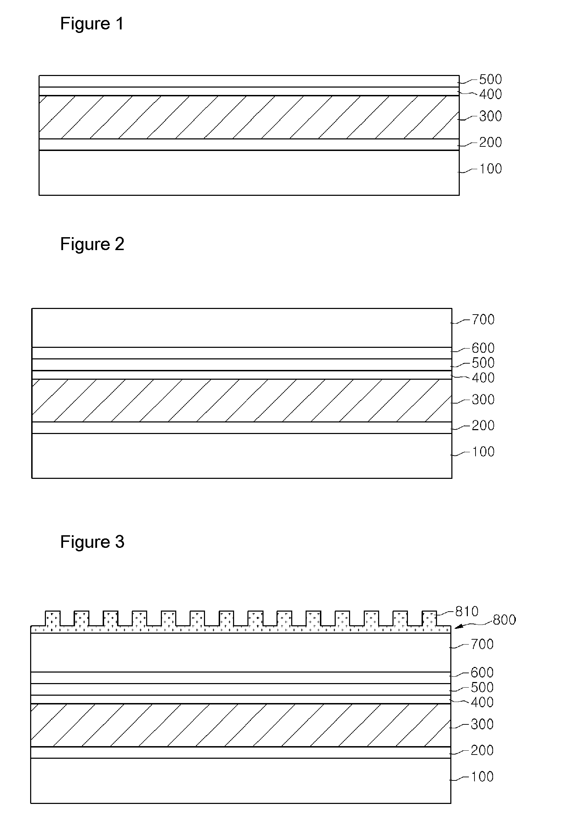

FIGS. 1 to 7 are cross-sectional views and perspective views showing a manufacturing method of a solar cell according to an exemplary embodiment.

### DETAILED DESCRIPTION

In describing exemplary embodiments, it will be understood that when, a substrate, a layer, a film, or an electrode is referred to as being "on" or "under" a layer, a film, or an electrode, "on" and "under" include "directly" or "indirectly". Further, "on" or "under" of each component will be described based on the drawings. The size of each component may be enlarged for description and does not represent an actually adopted size.

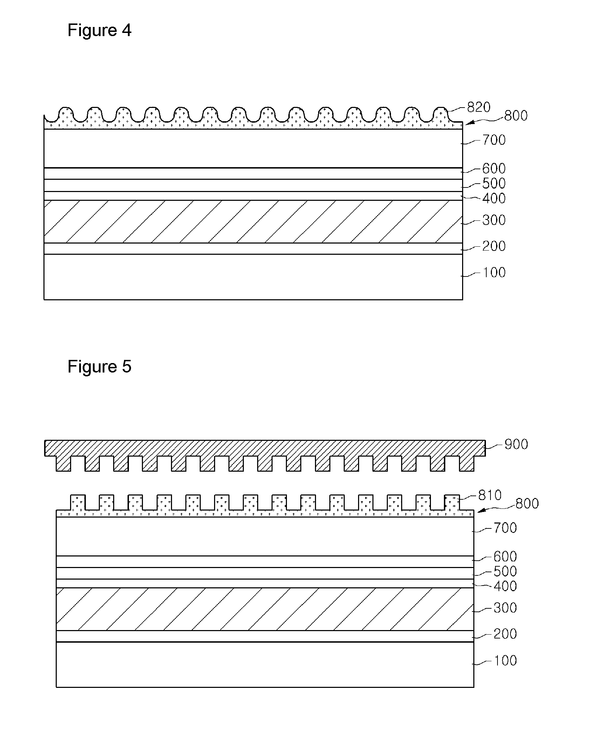

FIG. 3 is a side cross-sectional view of a solar cell according to an exemplary embodiment and FIG. 5 is a perspective view of a solar cell according to an exemplary embodiment.

The solar cell according to the exemplary embodiment includes a rear electrode 200, a light absorbing layer 300, a buffer layer 400, a front electrode 500, a transparent resin layer 600, an upper substrate 700, and a hologram pattern layer 800, as shown in FIGS. 3 to 5.

The hologram pattern layer 800 may be formed by forming a hologram forming material on the upper substrate 700 on the upper substrate 700 and forming a pattern.

The hologram forming material includes a single material such as epoxy, epoxy melanin, acryl, or a urethane resin or a mixture type resin and may be made of a transparent material.

In the hologram pattern layer 800, a curve of a quadrangular pyramid-shaped unevenness pattern 810 is periodically formed and the quadrangular pyramid-shaped unevenness pattern 810 may elongate in one direction.

However, the hologram pattern layer 800 is not limited to the quadrangular pyramid-shaped unevenness pattern 810 and as shown in FIG. 4, the hologram pattern layer 800 may be periodically formed in a sine wave pattern 820 in which the side surface of the hologram pattern layer 800 is curved.

The width W1 of the quadrangular pyramid-shaped unevenness pattern 810 may be in the range of 80 to 150 nm, the height of the quadrangular pyramid-shaped unevenness pattern 810 may be in the range of 100 to 300 nm, and the width W2 between the quadrangular pyramid-shaped unevenness pattern 810 may be in the range of 150 to 420 nm.

That is, the curve of the quadrangular pyramid-shaped unevenness pattern 810 may have a cycle in the range of 300 to 500 nm.

The hologram pattern layer 800 is formed on the upper substrate 700 and an interference pattern is generated due to an interference phenomenon generated in the hologram pattern layer 800 to provide an aesthetic sense and decorativeness.

Herein, the solar cell will be described in detail according to a manufacturing process of the solar cell.

FIGS. 1 to 7 are cross-sectional views and perspective views showing a manufacturing method of a solar cell according to an exemplary embodiment.

First, as shown in FIG. 1, the rear electrode 200, the light absorbing layer 300, the buffer layer 400, and the front electrode 500 are formed on the substrate 100.

Glass is used as the substrate 100 and a ceramic substrate, a metallic substrate, or a polymer substrate may be used.

Sodalime glass or high strained point soda glass may be used as the glass substrate and a substrate including strainless steel or titanium may be used as the metallic substrate.

Further, the substrate 100 may be rigid or flexible.

The rear electrode 200 may be made of a conductor such as metal.

For example, the rear electrode 200 may be formed through a sputtering process by using a molybdenum target.

This is to achieve high electrical conductivity of molybdenum (Mo), ohmic junction with the light absorbing layer, and high-temperature stability under a Se atmosphere.

A molybdenum (Mo) thin film which is the rear electrode 200 should have low specific resistance as an electrode and further, excellent adhesiveness onto a substrate so as to prevent a peeling phenomenon due to a difference in thermal expansion coefficient.

In addition, the material forming the rear electrode 200 is not limited thereto and may include indium tin oxide (ITO), natrium (Na), and molybdenum (Mo) doped with ions.

Further, the rear electrode 200 may be formed by at least one layer.

When the rear electrode 200 is formed by a plurality of layers, the layers constituting the rear electrode 200 may be made of different materials.

The light absorbing layer 300 includes a Ib-IIIB-VIb based compound.

More specifically, the light absorbing layer 300 includes a copper-indium-gallium-selenide based (Cu(In, Ga)Se₂, CIGS based) compound.

Contrary to this, the light absorbing layer 300 includes a copper-indium-selenide based (CuInSe₂, CIS based) CIGS based) compound or a copper-gallium-selenide based (CuGaSe₂, CIS based) compound.

For example, a CIG based metallic precursor layer is formed on the rear electrode 200 by using a copper target, an indium target, and a gallium target, in order to form the light absorbing layer 300.

Thereafter, the metallic precursor layer reacts with selenium (Se) to form the CIGS based light absorbing layer 300 by a selenization process.

Further, during the process of forming the metallic precursor layer and the selenization process, an alkali component included in the substrate 100 is diffused to the metallic precursor layer and the light absorbing layer 300 through the rear electrode pattern 200.

The alkali component can increase a grain size of the light absorbing layer 300 and improve crystallinity.

Further, the light absorbing layer 300 may be formed by co-evaporating copper (Cu), indium (In), gallium (Ga), and selenide (Se).

The light absorbing layer 300 receives external light to convert the received external light into electric energy. The light absorbing layer 300 generates photovoltaic force by a photoelectric effect.

The buffer layer 400 is formed by at least one layer and may be formed by plating any one of cadmium sulfide (CdS), ITO, ZnO, and i-ZnO or laminating cadmium sulfide (CdS), ITO, ZnO, and i-ZnO on the substrate 100 with the light absorbing layer 300.

In this case, the buffer layer 400 is an n-type semiconductor layer and the light absorbing layer 300 is a p-type semiconductor layer. Therefore, the light absorbing layer 300 and the buffer layer 400 form a pn junction.

The buffer layer 400 is placed between the light absorbing layer 300 and the front electrode to be formed thereon.

That is, since the difference in lattice constant and energy bandgap between the light absorbing layer 300 and the front electrode is large, the buffer layer 400 having a bandgap which is an intermediate between the bandgaps of both the materials is inserted between the light absorbing layer 300 and the front electrode to achieve an excellent junction.

One buffer layer is formed on the light absorbing layer 300 in the exemplary embodiment, but the buffer layer is not limited thereto and the buffer layer may be formed by a plurality of layers.

The front electrode 500 may be formed by a transparent conductive layer and may be made of zinc based oxide including foreign materials such as aluminum (Al), alumina (Al₂O₃), magnesium (MG), Gallium (Ga), and the like or indium tin oxide (ITO).

The front electrode 500 as a window layer that forms the pn junction with the light absorbing layer 300 serves as the transparent electrode on the front surface of the solar cell, and as a result, the front electrode 500 is made of a material having high light transmittance and high electric conductivity.

In this case, an electrode having a low resistance value may be formed by doping zinc oxide with aluminum or alumina.

Further, the front electrode 500 may be formed in a dual structure in which an indium tin oxide (ITO) thin film having a high electrooptical characteristic is evaporated on a zinc oxide thin film.

In addition, as shown in FIG. 2, the transparent resin layer 600 and the upper substrate 700 are formed on the front electrode 500.

The transparent resin layer 600 may be formed by an ethylene vinyl acetate copolymer (EVA) film.

The upper substrate 700 may be formed by low iron tempered glass or semi-tempered glass.

Subsequently, as shown in FIG. 3, the hologram pattern layer 800 is formed on the upper substrate 700.

The interference pattern is generated in the hologram pattern layer 800 due to the interference phenomenon and the interference pattern may provide the aesthetic sense and decorativeness.

The hologram pattern layer 800 may be formed by coating the upper substrate 700 with a hologram forming material and thereafter forming a pattern in the hologram forming material.

The hologram forming material includes a single material such as epoxy, epoxy melanin, acryl, or a urethane resin or a mixture type resin and may be made of a transparent material.

However, the hologram pattern layer 800 is not limited to the quadrangular pyramid-shaped unevenness pattern 810 and as shown in FIG. 4, the hologram pattern layer 800 may be formed in the sine wave pattern 820 in which the side surface of the hologram pattern layer 800 is curved.

Further, the curved sine wave pattern 820 may also be periodically formed.

In this case, in the pattern forming method, the hologram forming material is applied onto the upper substrate 700 and thereafter, a UV curing process is performed while a molding process is performed by using a mold 900 to form the pattern, as shown in FIG. 5.

The hologram material may be applied onto the upper substrate 700 by using a spin coating process.

However, the pattern forming method is not limited thereto, but the pattern may be formed by using a laser light source having excellent coherence after applying the hologram forming material onto the upper substrate 700.

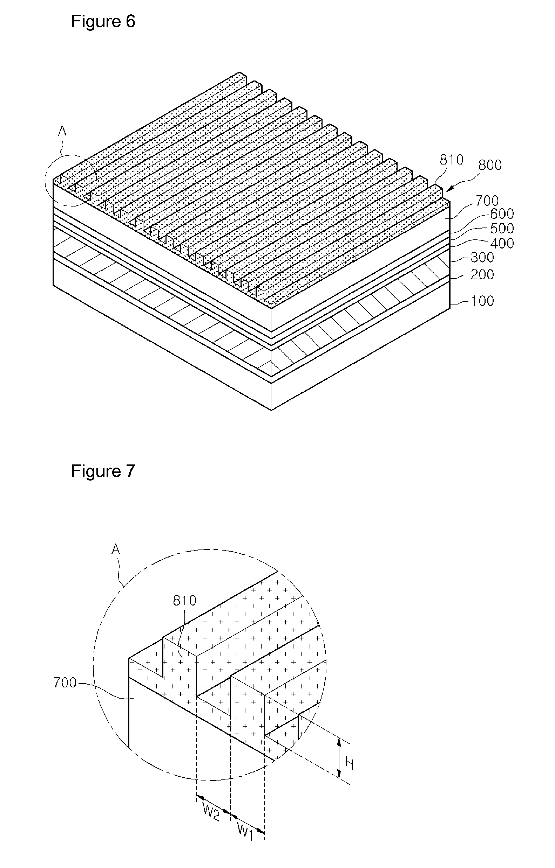

In the hologram pattern layer 800 formed through the above process, the curve of the quadrangular pyramid-shaped unevenness pattern 810 is periodically formed and as shown in FIG. 6, the quadrangular pyramid-shaped unevenness pattern 810 may elongate in one direction.

Further, when the hologram pattern layer 800 is formed in the curved sine wave pattern 820, the mold may be formed to correspond to the curved sine wave pattern.

FIG. 7 is an enlarged diagram of area A of the hologram pattern layer 800.

The width W1 of the quadrangular pyramid-shaped unevenness pattern 810 may be in the range of 80 to 150 nm and the height is in the range of 100 to 300 nm.

Further, the width W2 between the quadrangular pyramid-shaped unevenness patterns 810 may be in the range of 150 to 420 nm.

That is, the curve of the quadrangular pyramid-shaped unevenness pattern 810 may have a cycle in the range of 300 to 500 nm.

In the solar cell and the manufacturing method thereof according to the exemplary embodiments, the hologram pattern layer is formed on the upper substrate and the interference pattern is generated due to the interference phenomenon generated on the hologram pattern layer to provide the aesthetic sense and decorativeness.

While the present invention has been shown and described in connection with the exemplary embodiments, it will be apparent to those skilled in the art that modifications and variations can be made without departing from the spirit and scope of the invention as defined by the appended claims. For example, each component shown in detail in the exemplary embodiments may be modified and implemented. In addition, it should be understood that difference associated with the modification and application are included in the scope of the present invention defined in the appended claims.

## Claims

1. A solar cell, comprising:
an upper substrate placed on cells of the solar cell; and
a hologram pattern placed on the upper substrate.

2. The solar cell of claim 1, wherein the hologram pattern is a quadrangular pyramid-shaped unevenness pattern in which a curve is periodically formed.

3. The solar cell of claim 2, wherein in the quadrangular pyramid-shaped unevenness pattern, the width of a quadrangular pyramid is in the range of 80 to 150 nm and the height of the quadrangular pyramid is in the range of 100 to 300 nm, and a cycle of the quadrangular pyramid-shaped unevenness pattern is in the range of 300 to 500 nm.

4. The solar cell of claim 1, wherein the hologram pattern includes a curved sine wave pattern which is periodically formed.

5. The solar cell of claim 1, wherein the hologram pattern is made of a single material such as epoxy, epoxy melanin, acryl, or an urethane resin or a mixture type resin.

6. The solar cell of claim 1, wherein the upper substrate includes low-iron tempered glass or semi-tempered glass.

7. A manufacturing method of a solar cell, comprising:
forming an upper substrate on cells of the solar cell; and
forming a hologram pattern on the upper substrate.

8. The manufacturing method of a solar cell of claim 7, wherein the hologram pattern is formed by forming a pattern after coating the upper substrate with a single material such as epoxy, epoxy melanin, acryl, or an urethane resin which is a hologram forming material or a mixture type resin.

9. The manufacturing method of a solar cell of claim 8, wherein the hologram forming material is applied onto the upper substrate by using a spin coating method.

10. The manufacturing method of a solar cell of claim 8, wherein the hologram pattern is formed by performing both a molding process and a UV curing process with respect to the coated hologram material.

11. The manufacturing method of a solar cell of claim 7, wherein the hologram pattern is a quadrangular pyramid-shaped unevenness pattern in which a curve is periodically formed.

12. The manufacturing method of a solar cell of claim 11, wherein in the quadrangular pyramid-shaped unevenness pattern, the width of a quadrangular pyramid is in the range of 80 to 150 nm and the height of the quadrangular pyramid is in the range of 100 to 300 nm, and a cycle of the quadrangular pyramid-shaped unevenness pattern is in the range of 300 to 500 nm.

13. The manufacturing method of a solar cell of claim 7, wherein the hologram pattern includes a curved sine wave pattern which is periodically formed.
